# EUROPÄISCHE PATENTSCHRIFT

(11) **EP 1 724 827 B1**
(45) Veröffentlichungstag und Bekanntmachung des Hinweises auf die Patenterteilung: **23.11.2016**
(21) Anmeldenummer: 06113643.8
(22) Anmeldetag: 08.05.2006
(51) Int. Cl.: H01L 21/768, H01L 23/532

(54) **Verfahren zur Herstellung einer Leitstruktur mit Barrieren-Schichtstapel und entsprechende Leitstruktur**
Method of fabricating a conductor structure comprising a barrier layer stack and corresponding conductor structure
Procédé de fabrication d'une structure conductrice comprenant un empilage de couches de barrière et structure conductrice correspondante

(30) Priorität: 19.05.2005 DE 102005023122
(43) Veröffentlichungstag der Anmeldung: 22.11.2006
(60) Teilanmeldung: 10175130.3
(73) Patentinhaber: Infineon Technologies AG, 85579 Neubiberg (DE)
(72) Erfinder: Körner, Heinrich, 83052, Bruckmühl (DE)
(74) Vertreter: Kindermann, Peter

(56) Entgegenhaltungen:
- WO-A-01/29893
- US-A- 5 942 799
- US-A1- 2002 048 937
- US-A1- 2004 051 117
- US-A1- 2004 155 348
- US-B1- 6 500 761
- US-B1- 6 508 919

## Beschreibung

Die Erfindung betrifft Verfahren zur Herstellung integrierter Schaltungsanordnungen mit einer elektrisch leitfähigen Leitstruktur und mit einem zwischen der Leitstruktur und einem Dielektrikum an einer Seitenwand der Leitstruktur angeordneten Schichtstapel.

Die Leitstruktur ist beispielsweise eine Leitbahn zum lateralen Stromtransport oder ein Via zum vertikalen Stromtransport. Lateral bedeutet dabei parallel zu einer Hauptfläche eines Substrats der Schaltungsanordnung, wobei in der Hauptfläche eine Vielzahl integrierter Halbleiterbauelemente angeordnet sind. Vertikal bedeutet in Normalenrichtung oder entgegen der Normalenrichtung der Hauptfläche. Die Leitstruktur besteht beispielsweise aus Kupfer oder aus einer Kupferlegierung. Im Zusammenhang mit Kupfer-Leitstrukturen wird das sogenannte einfache Damaszener-Verfahren oder das sogenannte duale Damaszener-Verfahren verwendet. Die Leitstrukturen werden in ein Dielektrikum eingebettet, beispielsweise in Siliziumdioxid oder ein Dielektrikum mit einer kleinen relativen Dielektrizitätskonstante von beispielsweise kleiner als 3,9 bzw. kleiner als 3.

Um eine Diffusion des Kupfers in das Dielektrikum und anschließend in ein einkristallines Halbleitersubstrat zu verhindern, werden Schichtstapel verwendet, die auch eine gute mechanische Haftung zwischen dem Dielektrikum und der Leitstruktur gewährleisten sollen. Im Rahmen eines Damaszener-Verfahrens wird die Kupfer-Leitstruktur mit einem elektrolytischen Verfahren erzeugt, beispielsweise mit einer

Schichtdicke größer als 100 nm. Das elektrolytische Verfahren wird mit Außenstrom durchgeführt, wobei der Schichtstapel zur Stromleitung verwendet wird, beispielsweise weil am Waferrand ein festes Potential angelegt wird, das das Gegenpotential zu einer als Anode geschalteten Gegenelektrode ist.

Aus der WO 01/29893 A1 sind nanolaminierte Dünnfilme bekannt, deren Schichtdicken in einem Bereich liegen können, der sich über mehrere Zehnerpotenzen erstreckt und für die allgemein eine Vielzahl von Metallen verwendet werden können. Als Anwendungsgebiete sind Diffusionsbarrieren und Reflektoren bzw. Spiegel für Röntgenstrahlen angegeben.

Aus der US 6,500,761 B1 ist ein Verfahren zum Verbessern der Adhäsion und Haltbarkeit von CVD Ta und TaN modulierten Filmen durch Plasmabehandlung bekannt. Aus der US 2004/0051117 A1 ist ein Ersetzen einer Cu Seed/Ta/TaN Dreifachschicht-Barrierenanordnung durch eine direkt kupfergalvanisierbare Barriereschicht bekannt, die aus eine Kombination aus Ru and Ir und deren Oxiden besteht.

Aus der US 5,942,799 sind Mehrschichtdiffusionsbarrieren bekannt. Aus der US 6,508,919 B1 sind optimierte Auskleidungen für Dual-Damascene-Verdrahtungen bekannt.

Aus der US 2004/155348 A1 ist eine Barrierestruktur für Kupfermetallisierung bekannt.

Es ist Aufgabe der Erfindung, eine integrierte Schaltungsanordnung mit einem Schichtstapel anzugeben, der eine kleine Gesamtschichthöhe hat und dennoch als Diffusionsbarriere gegen Kupferdiffusion sowie als sogenannte Seed-Layer in einem elektrolytischen Kupfer-Abscheideverfahren verwendet werden kann. Außerdem soll ein Verfahren zur Kupferabscheidung angegeben werden.

Die Aufgabe wird durch Verfahren mit den in den Ansprüchen 1, 3 und 4 angegebenen Merkmalen gelöst. Die auf die Schaltungsanordnung bezogene Aufgabe wird durch eine Schaltungsanordnung mit den im Patentanspruch 14 angegebenen Merkmalen gelöst. Weiterbildungen sind in den Unteransprüchen angegeben.

Die Erfindung betrifft Verfahren zur Herstellung dünnster Mehrschichtstapel sowie solche Mehrschichtstapel, die als Ganzes sowohl als zuverlässige Haftschichten, als Diffusionsbarrieren und auch als Schichten für homogene und spontane Bekeimungen von nachfolgenden CVD- (Chemical Vapor Deposition) oder ECD-Metallabscheidungen (Electro Chemical Deposition) dienen und welche die Dicken-Forderungen der ITRS (International Technology Roadmap for Semiconductors) 2003, Update 2004, für zukünftige Technologien erfüllen. Die Mehrschichtstapel ermöglichen selbst bei größten Waferdurchmessern (z.B. 300 mm und größer) homogene und lunkerfrei füllende Abscheidungen in Single- oder Dual Damascene-Strukturen mit hohem Aspektverhältnis z.B. von größer als Eins. Insbesondere wird eine Abscheidung von Cu oder Wolfram durch elektrolytische, außenstromlose oder (MO)CVD-Prozesse (Metall Organisches CVD) möglich. Ein sich eventuell bildendes Oberflächenoxid soll - im Gegensatz zu Cu Seedlayern - nicht stören und nicht zu lunkerhaltigen Auffüllungen führen. Die erfindungsgemäßen Schichten zeigen deutlich geringere mechanische Stress-Werte als z.B. reine Ruthenium-Schichten und damit geringere Neigungen zur Delamination oder Riss- bzw. Crack-Bildung. Die Schichtstapel weisen bei gleicher Gesamtdicke wesentlich bessere Eigenschaften als Haft-, Barriere- und Nukleationsschicht auf als dicke Einzelschichten. Zum Erzielen vergleichbarer Ergebnisse wie bisher genügen somit geringere Gesamtschichtdicken.

Überraschenderweise zeigen dünnste Schichtkombinationen des Typs A/B/A, A/B/A/B/A, A/B/A/B/A/B/A, oder A/B/A', A/B/A'/B/A bzw. A' etc. die genannten Eigenschaften, wobei:
- Leitschichtmaterialien A beispielsweise Ruthenium (Ru), Wolfram (W), Rhodium (Rh), Rhenium (Re), Molybdän (Mo) oder Legierungen hieraus oder ähnliche Materialien darstellen, und
- Leitschichtmaterialien A' beispielsweise Ruthenium (Ru), Wolfram (W), Rhodium (Rh), Rhenium (Re), Molybdän (Mo), Kupfer (Cu), Silber (Ag), Gold (Au), Palladium (Pd), Platin (Pt) oder Legierungen hieraus oder ähnliche Materialien darstellen. Als A' Materialien kommen bspw. auch Nickel (Ni), Chrom (Cr) oder Kobalt (Co) in Frage, insbesondere wenn das darunter angeordnete Material B elementar ist, d.h. nur eine Atomart enthält.
- Zwischenschichtmaterialien B beispielsweise Ta, TaN, eine Doppelschicht TaN/Ta, TaC, TaCN, TaSiN,
   WN, WC, WCN, WSiN,
   TiN, TiC, TiCN, TiSiN,
   Al, Cr, Ni, Co, Pd, Pt, C oder Legierungen hieraus oder ähnliche Materialien darstellen.

Die Schichtstapel enthalten somit mindestens drei Schichten, wobei Leitschichten mit Zwischenschichten abwechseln und der Schichtstapel bspw. mit einer Leitschicht beginnt. Mehrere Zwischenschichten bestehen jeweils bspw. aus dem gleichen Material oder aus voneinander verschiedenen Materialien. Ebenso bestehen die Leitschichten jeweils aus dem gleichen Material oder aus voneinander verschiedenen Materialien.

Während z.B. reine Ruthenium-Schichten von 20, 30 oder 40 nm Dicke aufgrund ihrer kolumnaren Struktur keine ausreichende Cu-Diffusionsbarrieren sind und somit noch zusätzliche Barrierenschichten benötigen, ist z.B. die A/B/A/B/A - Schichtkombination mit A ≤ 5 nm Ru und B ≤ 2 nm TaN sehr wohl eine ausreichende Cu-Diffusionsbarriere.

Bei den Materialien der Gruppe A handelt es sich typischerweise um niederohmige Refraktärmetalle, d.h. um Metalle mit Schmelztemperatur größer als 1600 °C oder sogar größer als 2000 °C. Die Gruppe A' ist im Vergleich zur Gruppe A erweitert um niederohmige Halbedelmetalle, z.B. Cu, oder niederohmige Edelmetalle. Niederohmig bedeutet, dass der spezifische Widerstand ρ ≤ 50 μΩcm oder ρ ≤ 20 μΩcm ist, gemessen bspw. an einem Volumenmaterial (bulk), bspw. einer Schicht mit einer Dicke von 200 nm oder größer. Die Materialien der Gruppe A bzw. A' sind häufig mit Cu oder anderen Leitbahnmaterialien weder legierbar noch mischbar. Die minimale benötigte Dicke der A-Materialien bzw. A'-Materialien wird durch den noch zulässigen Schicht-Widerstand bei der nachfolgenden elektrolytischen Cu-Abscheidung sowie durch die Anzahl der A-Schichten bzw. bzw. A'-Schichten bestimmt. Um gleichzeitig wirkungsvolle Diffusionsbarrieren zu erzeugen, erwies es sich als besonders vorteilhaft, den Abscheideprozess für die AKomponente bzw. A'-Komponente ein- oder mehrmals zu unterbre-chen und mindestens einmal extrem dünne (≤ 2nm) Schichten oder Prozesse der B-Komponenten einzubringen.

Bei den Materialien der Gruppe B handelt es sich typischerweise um leitfähige Schichten mit Cu-Diffusionssperrwirkung. Aufgrund ihrer eigenen Leitfähigkeit tragen sie auch zur Leitfähigkeit des Schichtstapels und damit zu dessen Funktion als Bekeimungsschicht für nachfolgende Abscheideprozesse bei, die eine gewisse Mindestleitfähigkeit benötigen. Noch wichtiger aber ist der Beitrag der B-Komponenten zur Barrierenwirkung. Sie wirken nicht nur selbst diffusionshemmend, sondern modifizieren überraschenderweise auch das Wachstum der nach-folgenden A-Komponente bzw. bzw. A'-Komponente. Während diese in dickeren Einzelschichten bevorzugt kolumnar wachsen, bewirken zwischengelagerte dünne und somit oft amorph ausgestaltete B-Komponenten ein zunächst ebenfalls amorph einsetzendes Wachstum der A-Komponenten bzw. A'-Komponenten. Im Gegensatz zu den kolumnar ausgeprägten A-Komponenten bzw. A'-Komponenten tragen die entsprechenden amorphen oder röntgenamorphen A-Spezies bzw. A'-Spezies ebenfalls zur Barrierenwirkung bei.

Neben der Abscheidung von dünnen B-Komponenten erfüllen bei einer Weiterbildung auch folgende Schritte eine analoge Wirkung:
- Unterbrechung der A-Abscheidung bzw. der A'-Abscheidung und Temperung bei bis zu 400°C in Gasgemischen, die eine oder mehrere der Komponenten N₂, Ar, O₂, NH₃, Kohlenwasserstoffe oder H₂ enthalten.
- Unterbrechung der A-Abscheidung bzw. der A'-Abscheidung und Plasma-Flash oder kurzer Sputterschritt mit Gasgemischen, die eine oder mehrere der Komponenten N₂, Ar, O₂, NH₃, Kohlenwasserstoffe oder H₂ enthalten.

Eine Weiterbildung ist dadurch gekennzeichnet, dass die Abscheidung mindestens einer Leitschicht mindestens einmal unterbrochen wird,
dass nach der Unterbrechung ein Temperschritt durchgeführt wird,
und dass die Abscheidung der Leitschicht nach dem Temperschritt fortgesetzt wird ohne dass zwischenzeitlich andere Materialien auf dem bereits abgeschiedenen Teil der Leitschicht abgeschieden werden.

Eine alternative Weiterbildung ist dadurch gekennzeichnet, dass die Abscheidung mindestens einer Leitschicht mindestens einmal unterbrochen wird,
dass nach der Unterbrechung für eine Zeitdauer kleiner als 20 Sekunden ein Plasma gezündet wird oder dass nach der Unterbrechung für eine Zeitdauer kleiner als 20 Sekunden ein Rücksputterschritt durchgeführt wird,
und dass nach dem Plasmalöschen bzw. nach dem Rücksputterschritt die Abscheidung der Leitschicht fortgesetzt wird ohne dass zwischenzeitlich andere Materialien auf dem bereits abgeschiedenen Teil der Leitschicht abgeschieden werden.

In Summe wird damit erreicht, dass im Vergleich zum Zwei- bzw. Dreischichtschichtsystem des Typs B/A bzw. B/B'/A (z.B. TaN/Ta/Cu) geringere Gesamtdicken an Barrierekomponente B benötigt werden, um die gleiche Barrierewirkung zu erreichen. Gleichzeitig werden keine dickeren Schichten der A-Komponente bzw. A'-Komponente für die "seed-layer"-Funktion als im Vergleichsfall benötigt.

Bei einer nächsten Weiterbildung wird ausgenutzt, dass beispielsweise Ruthenium ein Oxid (RuO₂) bildet, das eine zum reinen Metall vergleichbare Leitfähigkeit von etwa 20 μΩcm besitzt. Somit wird es möglich, eine beispielsweise A/B/A/B/A-Schichtenfolge zunächst mit einer dünnen A-OxidSchicht zu beginnen, welche dann kontinuierlich oder abrupt in eine reine A-Schicht übergeht. Dieses A-Oxid zeigt eine sehr gute Haftung zu den typischen IMD-Materialien (InterMetallDielektrikum) wie z.B. SiO₂ bzw. SiCOH und macht zusätzliche Haftschichten überflüssig, wie sie bei Cu-Seedlayern bzw. Cu-Wachstumskeimbildungsschichten benötigt werden. Aufgrund der hohen Leitfähigkeit von RuO₂ stört eine oberflächlich ausgebildete Oxidschicht nachfolgende Prozesse wie z.B. elektrolytische Cu-Abscheidung nicht und diese Abscheidungen können reproduzierbarer, sicherer, gleichmäßiger und lunkerfrei erfolgen.

Geeignete Abscheidemethoden für A-Komponenten bzw. A'-Komponenten sind PVD (Physical Vapor Deposition, insbesondere Verfahren mit einer hohen Plasmadichte und/oder hohem Ionisierungsgrad des abzuscheidenden Materials, z. B. IPVD (Ionized PVD) oder SIP (Self Ionized Plasma). Andere Abscheidemethoden sind CVD (Chemical Vapor Deposition), ALD (Atomic Layer Deposition), galvanische oder stromlose Verfahren oder auch SFD (Supercritical Fluid Deposition) mit z.B. superkritischem CO₂. Für B-Komponenten eignen sich prinzipiell die gleichen Methoden. Bevorzugterweise werden die Multischichten in Mehrkammeranlagen erzeugt, wie z.B. einer "Endura" von Applied Materials. Diese bieten die Möglichkeit, die Schichten mit allen notwendigen Vor- und Nachbehandlungen mit oder ohne Vakuum-Unterbrechung unter Einsatz verschiedener Parameter (wie Temperatur, Druck, Gasflüsse) oder verschiedener Medien in einer oder mehreren Abscheidekammern unmittelbar hintereinander zu erzeugen und damit schnell, gut kontrolliert und kostengünstig.

Optional kann vor der Erzeugung des Schichtstapels:
- ein Reinigungsschritt z.B. zur Entfernung von Oberflächen-oxiden auf bereits vorhandenen Metall-Lagen,
- die Abscheidung einer separaten, dünnen Haft- oder Nukleationsschicht,
- ein Schritt zum Versiegeln von Poren in porösen low-k Materialien,
oder ähnliches ausgeführt werden.

Optional kann sich an die Erzeugung des Schichtstapels:
- die Abscheidung einer sehr dünnen Cu-Schicht, z.B. dünner als 1 nm oder dünner als 3 nm,
- ein Reinigungsschritt zur Generierung definierter Oberflächen,
- ein Anneal- oder Temperschritt,
- die Abscheidung eines Materials, welches als Leitbahnmaterial fungiert,
oder ähnliches anschließen.

Die Vorteile der erfindungsgemäßen multifunktionalen Schichtstapel lassen sich wie folgt zusammenfassen:
- großer effektiver Bahnquerschnitt der Kupferleitstruktur und damit verbundene hohe Stromtragfähigkeit, insbesondere nimmt der Schichtstapel auch bei minimalen lateralen Abmessungen der Leitstruktur von kleiner als 100 nm nur weniger als 10 Prozent des Gesamtbahnquerschnitts ein,
- exzellente Eigenschaften als diffusionshemmende Barriereund niederohmige Bekeimungsschichten bei geringsten Schichtdicken für Einzelkomponenten und Schichtstapel,
- zuverlässige, spontane und gleichmäßige Bekeimung bei nachfolgenden Prozessen wie z.B. Cu-ECD (Electro Chemical Deposition) oder -(MO)CVD sowohl lateral über den gesamten Wafer als auch in Strukturen mit anspruchsvollsten Aspektverhältnissen z.B. größer als 1 oder größer als 2) und Geometrien (z.B. minimale Abmessungen kleiner als 100 nm),
- geringste Rauhigkeit des Schichtstapels und des nachfolgend abgeschiedenen "Leitbahnmaterials",
- ermöglicht lunkerfreie Füllung von Damascene-Strukturen und damit Erzeugung hochstromtragender Leitbahnen,
- skalierbar,
- wenig sensitiv bezüglich Bildung von Oberflächen-Oxiden,
- Minimierung oder gezielte Einstellung von z.B. bestimmten Schicht-Stresswerten über die Schichtkombination möglich und somit geringste Gefahr für Delaminationen, Crackbildung etc.,
- Materialien und Methoden in großem Umfang wähl- und kombinierbar,
- Kombinierbar mit Vor- und Nachbehandlungsschritten,
- Kostengünstig,
- Geeignet für Damascene als auch für subtraktive Architekturen.

Die Erfindung betrifft außerdem ein Verfahren zur Herstellung der erfindungsgemäßen Schaltungsanordnung oder einer ihrer Weiterbildungen. Bei einer Weiterbildung des Verfahrens wird eine elektrolytische Kupferabscheidung mit Außenstrom ohne Verwendung einer Kupferkeimbildungsschicht direkt auf dem Schichtstapel aufgebracht.

Es werden also Verfahren zur Erzeugung von ultradünnen niederohmigen Schichtstapeln sowie solche Schichtstapel angegeben, die sowohl als Haft-, Barriere- und Bekeimungsschicht in Mehrlagenmetallisierungen von integrierten Schaltkreisen dienen. Die Schichtstapel bestehen aus mindestens zwei unterschiedlichen Schichtmaterialien, von denen mindestens ein Material (B) amorph oder teilweise amorph ist und welches das andere Material (A) bzw. die anderen Materialien (A, A') mindestens einmal unterbricht.

Im folgenden werden Ausführungsbeispiele der Erfindung an Hand der beiliegenden Zeichnungen erläutert. Darin zeigen:
- Figur 1: einen Querschnitt durch die Metallisierung einer integrierten Schaltungsanordnung entlang der Normalenrichtung zur Oberfläche eines nicht dargestellten Halbleitersubstrats,
- Figur 2: einen Schichtstapel mit zwei Zwischenschichten,
- Figur 3: einen Schichtstapel mit einer Zwischenschicht, und
- Figur 4: einen Schichtstapel für einen Wolframkontakt.

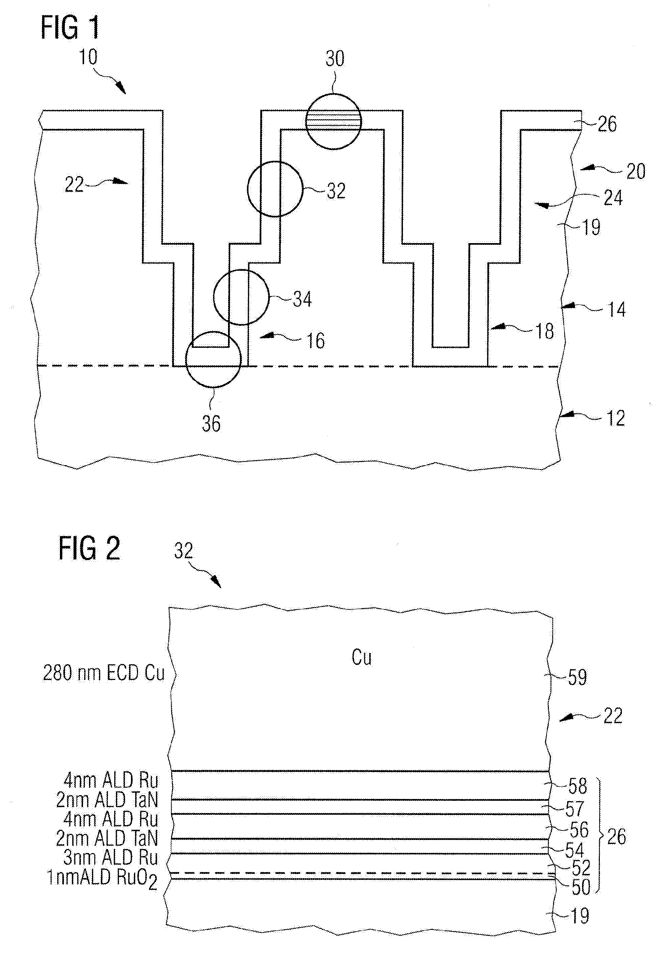

Figur 1 zeigt einen Querschnitt durch die Metallisierung einer integrierten Schaltungsanordnung 10 entlang der Normalenrichtung zur Oberfläche eines nicht dargestellten Halbleitersubstrats, z.B. eines einkristallinen Siliziumsubstrats. Die Schaltungsanordnung 10 enthält eine untere Metallisierungslage 12. An die untere Metallisierungslage 12 schließt sich nach oben hin eine Vialage 14 an, die Kupfervias 16 und 18 enthält. Die Vialage 14 befindet sich in einer Isolierschicht 19, in der auch eine Leitbahnlage 20 angeordnet ist, die Leitbahnen 22 und 24 enthält. Im Ausführungsbeispiel werden die Vialage 12 und die Leitbahnlage 20 mit Hilfe eines dualen Damaszener-Verfahrens hergestellt, wobei nach dem Erzeugen der Aussparungen für die Vias 16, 18 und für die Leitbahnen 22, 24 ganzflächig und konform ein Schichtstapel 26 abgeschieden wird, dessen Aufbau weiter unten noch näher erläutert wird.

Auf Grund der konformen Abscheidung sind die folgenden Ausschnitte des Schichtstapels 26 im wesentlichen identisch:
- ein Ausschnitt 30 an der Oberfläche der Isolierschicht zwischen zwei Leitbahnen 22, 24, wobei der den Ausschnitt 30 enthaltende Teil des Schichtstapels 26 bei einem anschließenden Planarisierungsschritt wieder entfernt wird,
- ein Ausschnitt 32 an der Seitenwand der Leitbahn 22, insbesondere auf halber Höhe der Seitenwand,
- ein Ausschnitt 34 an der Seitenwand des Vias 16, insbesondere auf halber Höhe der Seitenwand, und
- ein Ausschnitt 36 am Boden des Vias 16, wobei bei diesem Ausschnitt 36 der Schichtstapel 26 nicht am Dielektrikum 19 sondern auf dem Metall der unteren Metallisierungslage angeordnet ist.

An Stelle der unteren Metallisierungslage wird auch eine polykristalline Leitstruktur, z.B. aus Silizium, verwendet. Schichtstapel, die in ihrem Aufbau dem Schichtstapel 26 entsprechen, sind bei anderen Ausführungsbeispielen auch in höheren Metallisierungslagen angeordnet, insbesondere in allen höheren Kupfermetallisierungslagen. alternativ werden solche Schichtstapel nur in einer oder in zwei Metallisierungslagen erzeugt, während in anderen Kupfer-Metallisierungslagen der Schaltungsanordnung andere Barriereschichten oder andere Barriereschichtstapel verwendet werden. Figur 2 zeigt den Ausschnitt 32 des Schichtstapels 26 mit zwei Zwischenschichten 54 und 57. Vorhergehende Prozessschritte zur Herstellung mikroelektronischer Bauelemente auf entsprechenden Substraten sind bekannt und werden deshalb nicht näher erläutert. Das Substrat ist bspw. ein einkristalliner Siliziumwafer oder ein SOI-Wafer (Silicon On Insulator). Der Wafer hat bspw. einen Durchmesser größer oder gleich 200 Millimeter oder größer oder gleich 300 Millimeter.

Es wird eine erste Isolationsschicht abgeschieden und es werden Durchkontaktierungen erzeugt, z.B. durch Füllung mit Wolfram per CVD (chemical Vapor Deposition) und CMP (chemical Mechanical Polishing) gemäß dem Stand der Technik.

Danach erfolgt bspw. die Abscheidung einer dielektrischen Barriere, z.B. von 30 nm PECVD-SiN (Plasma Enhanced CVD Siliziumnitrid) oder PECVD-SiCN (Siliziumcarbonitrid). Anschließend wird die elektrisch isolierende Schicht 19 erzeugt, bspw. durch Abscheidung von mindestens 100 nm dielektrischem Material, wie PECVD SiO₂ (Siliziumdioxid), SiCOH (Hydrogenated Oxidized Silicon Carbon), oder anderen low-k Materialien als IMD (Intermetalldielektrikum) sowie optionaler Hartmasken und Hilfsschichten mittels bekannter Techniken der Halbleiterherstellung.

Danach werden in der Schicht 19 Gräben und/oder Vias durch bekannte Abfolgen von Belackung, lithographischer Belichtung und Erzeugung von Lackmasken, plasmaunterstützter Ätzschritte und Lackstripp-Verfahren mittels bekannter Techniken der Halbleiterherstellung erzeugt. Die minimalen lateralen Strukturbreiten des Grabens für die Leitbahn 22 sind dabei bspw. kleiner als 100 Nanometer.

Dann wird die dielektrische Barriere geöffnet, bspw. durch plasmaunterstützte Ätzschritte mittels bekannter Techniken der Halbleiterherstellung. Der Wafer wird danach in eine Multikammeranlage zur Abscheidung von metallischen Schichten eingebracht, bspw. in eine Multikammeranlage mit einem Grundvakuumdruck kleiner als 10 mTorr bzw. 1,3 Pa. Es wird ein optionaler Degas- und Reinigungsschritt mittels bekannter Techniken der Halbleiterherstellung durchgeführt, bspw. physikalisch oder nasschemisch.

Nachdem der Wafer in eine ALD-Kammer (Atomic layer Deposition) eingebracht worden ist, werden bspw. 1 nm (Nanometer) ALD RuO₂ einer Haftschicht 50 und 3 nm Ru einer ersten Leitschicht 52 bei bspw. T = 280 °C (Grad Celsius) abgeschieden, bspw. unter Verwendung von abwechselnden Pulsen von Ru(C₂H₅C₅H₄)₂ [Bis(ethylcyclopentadienyl)ruthenium (II)] sowie sauerstoffhaltigen Gasgemischen, zwischen denen jeweils ein kurzer Spülschritt mit Inertgas erfolgt, z.B. mit molekularem Stickstoff N₂. Um zu Beginn bspw. eine ein Nanometer dicke Haftschicht 50 aus RuO₂ abzuscheiden, wird anfänglich als Reaktionspartner ein Sauerstoff-Argon-Gasgemisch mit 85 Prozent Sauerstoff O₂ bezogen auf die Gesamtgasmenge des Sauerstoff-Argon-Gasgemisches verwendet. Nach Abscheidung von ca. 1 nm RuO₂ wird mit einem Sauerstoff-Argon-Gasgemisch von 42 Prozent Sauerstoff bezogen auf die Gesamtgasmenge des Sauerstoff-Argon-Gasgemisches reines Ruthenium Ru für die erste Leitschicht 52 mit einem spezifischen elektrischen Widerstand p = 17 μΩcm (Mikroohmzentimeter) abgeschieden. Die Abscheiderate liegt bspw. bei 0,16 nm/Zyklus bzw. bei 1,6 Angström je Zyklus.

Der Wafer wird dann in eine zweite ALD-Kammer transportiert, z.B. in eine Kammer der selben Anlage, insbesondere in eine der zuvor benutzten ALD-Kammer benachbarte ALD-Kammer. Hier werden bspw. 2 nm ALD TaN (Tantalnitrid) einer ersten Zwischenschicht 54 direkt auf der ersten Leitschicht 52 abgeschieden, bspw. unter Verwendung von abwechselnden Pulsen von Tantal-Tris(diethylamino)-t-butylimid sowie Ammoniak NH₃, zwischen denen jeweils ein kurzer Spülschritt bspw. mit Inertgas (N₂/Ar) erfolgt. Die Temperatur in der Kammer beträgt bspw. T = 260°C. Die Abscheiderate liegt bspw. bei 0,4 Angström/Zyklus.

Danach wird der Wafer bspw. wieder in die zuerst benutzte ALD-Kammer eingebracht, wo bspw. 4 nm ALD Ru einer zweiten Leitschicht 56 bei den gleichen Prozessbedingungen wie beim Abscheiden der ersten Leitschicht 52 abgeschieden werden. Die zweite Leitschicht 56 wird unmittelbar auf der Zwischenschicht 54 erzeugt, so dass die Zwischenschicht 54 und die zweite Leitschicht 56 aneinander grenzen.

Anschließend wird der Wafer wieder in die zweite ALD-Kammer transportiert, wo bspw. 2 nm ALD TaN einer zweiten Zwischenschicht 57 auf der zweiten Leitschicht 56 unter den gleichen Prozessbedingungen wie beim Erzeugen der ersten Zwischenschicht 54 abgeschieden werden.

Danach wird der Wafer nochmals in die zuerst benutzte ALD-Kammer eingebracht. In der zuerst benutzten Kammer wird auf der zweiten Zwischenschicht 57 eine dritte Leitschicht 58 erzeugt, die bspw. eine Schichtdicke von 4 nm hat und die eine ALD Rutheniumschicht ist. Beim Abscheiden der dritten Leitschicht 58 werden wieder die gleichen Abscheidebedingungen verwendet, wie beim Abscheiden der ersten Leitschicht 52.

Es entsteht ein Schichtstapel 26 der in der folgenden Reihenfolge enthält:
- eine untere Haftschicht 50, die einen spezifischen elektrischen Widerstand von etwa 20 Mikroohmzentimetern hat,
- eine erste Leitschicht 52 aus Ruthenium mit einen spezifischen elektrischen Widerstand von etwa 10 Mikroohmzentimetern,
- eine erste Zwischenschicht 54 mit einen spezifischen elektrischen Widerstand von etwa 200 Mikroohmzentimetern,
- eine zweite Leitschicht 56 aus Ruthenium mit einen spezifischen elektrischen Widerstand von etwa 10 Mikroohmzentimetern,
- einer zweite Zwischenschicht 57 mit einen spezifischen elektrischen Widerstand von etwa 200 Mikroohmzentimetern,
- eine dritte Leitschicht 52 aus Ruthenium mit einen spezifischen elektrischen Widerstand von etwa 10 Mikroohmzentimetern.

Obwohl die Leitschichten 52, 56 und 58 vorrangig dem Stromtransport beim elektrolytischen Abscheiden des Kupfers dienen, d.h. die klassische Funktion einer Seedlayer haben, erbringen sie auch Funktionen einer Kupferdiffusionsbarriere, insbesondere auf Grund amorpher Teilschichten an den Grenzen zur jeweils darunter angeordneten Zwischenschicht 54 bzw. 57. Ebenso dienen zwar die Zwischenschichten 54 und 57 vorrangig als Kupfer-Diffusionsbarriere. Jedoch fließt durch die Zwischenschichten bei der elektrolytischen Kupferabscheidung auch ein Strom, insbesondere quer zur Zwischenschicht und in lateraler Richtung der Zwischenschicht.

Dann wird das Substrat bzw. der Wafer aus der Multikammeranlage zur Prozess-Station für elektrolytische Cu-Abscheidungen gebracht. Hier erfolgt die Abscheidung einer Bulk-Leitstrukturschicht 59 aus Kupfer mit einer Schichtdicke von mehr als 100 Nanometern, bspw. mit einer Schichtdicke von 280 nm. Es werden bekannte elektrolytische Verfahren benutzt, bspw. bei Raumtemperatur mit abschließender Reinigung des Substrates durch Spülung mit DI-Wasser (DeIonisiertes Wasser) und i-Propanol (Isopropanol).

Danach wird eine Temperung des beschichteten Substrates bei einer Temperatur größer als 100 °C für bspw. mehr als 10 Minuten durchgeführt, bspw. bei 150°C für 15 min. Bspw. wird in Formiergas mit 95 Prozent molekularer Stickstoff und 5 Prozent molekularer Wasserstoff getempert. Die Tempertemperatur ist jedoch kleiner als 450 °C oder kleiner als 350 °C.

Nach dem Tempern werden über den Graben bzw. das Via hinausragende Kupferbereiche, Mehrschichtbarrierebereiche sowie Dielektrikumsanteile durch mindestens einen CMP-Schritt mit nachfolgender Reinigung mittels bekannter Techniken der Halbleiterherstellung entfernt. Die weitere Prozessführung und Fertigstellung erfolgt gemäß dem Stand der Technik, wobei die oben genannte Prozessführung zur Bildung von Mehrlagenmetallisierungen auch wiederholt durchgeführt wird.

Bei einem alternativen Ausführungsbeispiel werden die Schichten 50 bis 58 mit einem CVD-verfahren oder einige Schichten mit ALD-Verfahren und andere Schichten mit einem CVD-Verfahren erzeugt.

Bei einem nächsten Ausführungsbeispiel enthält der Schichtstapel 26 zusätzlich noch eine obere dritte Zwischenschicht, die wie die erste Zwischenschicht 54 aufgebaut ist, sowie eine obere vierte Leitschicht, die wie die erste Leitschicht 52 aufgebaut ist. In diesem Fall werden die Leitschichten und die Zwischenschichten jedoch dünner als an Hand der Figur 2 erläutert ausgeführt. Bei anderen Ausführungsbeispielen werden weitere Zwischenschichten und Leitschichten hinzugefügt, wobei die Schichtdicken der einzelnen Schichten weiter verringert werden. Die letzte Schicht des Schichtstapel ist eine Leitschicht, die an die Leitstruktur grenzt.

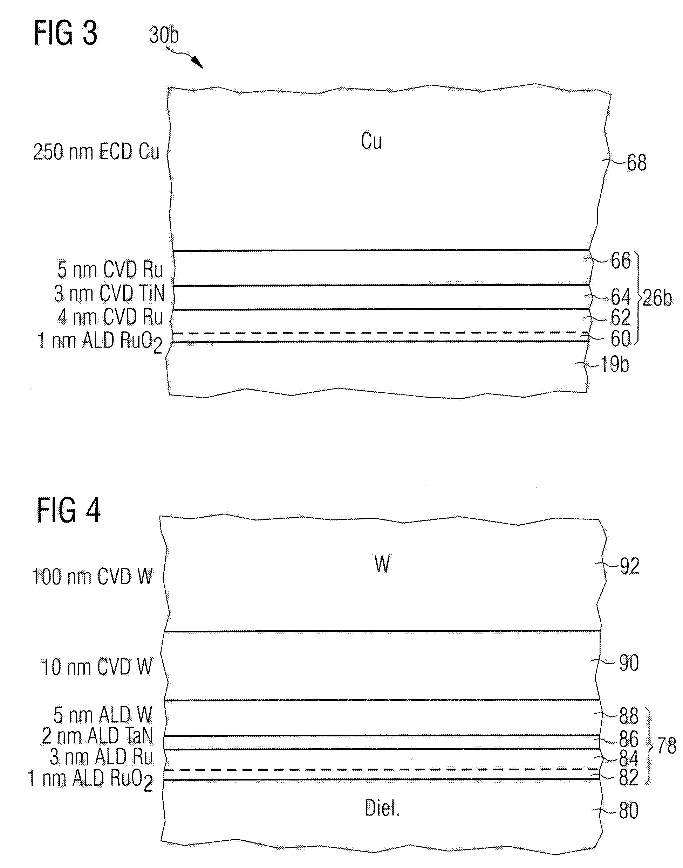

Figur 3 zeigt einen Schichtstapel 26b mit nur einer Zwischenschicht 64. Zunächst werden die oben an Hand der Figur 2 erläuterten Prozessschritte einschließlich des optionalen Degas- und Reinigungsschrittes durchgeführt.

Danach wird der Wafer, auf dem die Isolierschicht 19b aufgebracht ist, in eine CVD-Kammer eingebracht. Es werden bspw. 1 nm CVD-RuO₂ einer Haftschicht 60 und 4 nm einer ersten Leitschicht 62 aus Bis(cyclopentadienyl)ruthenium (II) und O₂-Ar-Gemischen bei bspw. 315 °C abgeschieden. Um zu Beginn RuO₂ abzuscheiden, wird anfänglich als Reaktionspartner ein Gasgemisch aus Sauerstoff O₂ und Argon mit 90 Prozent Sauerstoff O₂ verwendet. Nach Abscheidung von ca. 1 nm RuO₂ wird mit O₂/(O₂ + Ar) = 22 Prozent reines Ruthenium mit einem spezifischen elektrischen Widerstand p = 13μΩcm abgeschieden.

Der Wafer wird dann in eine weitere CVD-Kammer transportiert, bspw. in eine der zuerst benutzten CVD-Kammer benachbarte Kammer derselben Anlage. In der weiteren Kammer werden bspw. 3 nm CVD-TiN einer Zwischenschicht 64 aus Tetrakis(dimethylaminotitan) bei bspw. 350 °C und bspw. 4 Torr Gesamtdruck direkt auf der ersten Leitschicht 62 abgeschieden. Ein optionaler nachfolgender N₂/H₂-Plasma-Schritt (z. B. erzeugt durch Einkopplung einer HF-Spannung von 13,56 MHz, und einer Leistung von bspw. 5 W/cm²) dient zur Verdichtung und Stabilisierung der Schicht.

Danach wird der Wafer wieder in die zuerst genutzte CVD-Kammer oder in eine andere CVD-Kammer transportiert. Hier wird eine bspw. 5 nm starke CVD-Ru zweite Leitschicht 66 bei den gleichen Prozessbedingungen wie die erste Leitschicht 62 abgeschieden. Die zweite Leitschicht 66 hat wie die anderen mit einem ALD- bzw. CVD-Verfahren abgeschiedenen Schichten eine im wesentlichen gleichbleibende Schichtdicke mit Dickeschwankungen kleiner als 10 Prozent bezogen auf den mittleren Schichtdickewert dieser Schicht.

Nach dem Erzeugen der zweiten Leitschicht 66 wird der Wafer bzw. das Substrat aus der Multikammeranlage zur Prozess-Station für elektrolytische Cu-Abscheidungen transportiert, wo sich die oben an Hand der Figur 2 erläuterten Prozessschritte anschließen, d.h. insbesondere elektrolytische Abscheidung einer bspw. 250 nm dicken Kupferschicht 68 für eine Leitbahn und/oder für eine Viafüllung, die Temperung und die weitere Bearbeitung.

Bei einem alternativen Ausführungsbeispiel werden die Schichten 60 bis 66 mit einem ALD-Verfahren oder einige Schichten mit CVD-Verfahren und andere Schichten mit einem ALD-Verfahren erzeugt.

Figur 4 zeigt einen Schichtstapel 78 zur Auskleidung eines Wolframkontaktes 92, der Teil der ersten Metallisierungslage ist, die unmittelbar benachbart zu einem einkristallinen Halbleitersubstrat liegt. Die Figur 4 gilt für einen Schichtstapel 78 an einer Seitenwand des Kontaktes 92, wobei der Schichtstapel 78 an ein Dielektrikum 80 grenzt, das aus einem elektrisch isolierenden Material besteht. Jedoch befindet sich ein dem Schichtstapel 78 identischer Schichtstapel auch am Boden des Wolframkontaktes, wobei jedoch an Stelle des Dielektrikums 80 das Halbleitersubstrat liegt, ggf. versehen mit einer dünnen Silizidschicht.

Es werden die der Erzeugung des Schichtstapel 78 vorhergehenden Prozessschritte zur Herstellung mikroelektronischer Bauelemente auf entsprechenden Substraten wie z. B. Siliziumwafern durchgeführt. Bspw. werden eine Vielzahl von Transistoren eines Prozessors oder eines Halbleiterspeichers erzeugt, z.B. eines flüchtig speichernden RAM (Random Access Memory) oder eines nicht flüchtig speichernden Halbleiterspeichers.

Zum Erzeugen der untersten Metallisierungslage werden bspw. 20 nm Siliziumnitrid SiN sowie bspw. 600 nm Isolationsschicht 80 aus BPSG (BorPhosphor SilikatGlas) und/oder TEOS-SiO2 (Tetra Ethyl Ortho Silikat) und thermisches Verfließen bei Temperaturen größer als 600 °C mittels bekannter Techniken der Halbleiterherstellung abgeschieden. Es folgt eine Planarisierung des Dielektrikums 80 durch Chemisch-Mechanisches Polieren (CMP) oder auf andere Art mittels bekannter Techniken der Halbleiterherstellung.

Danach werden Kontaktlöcher und/oder sogenannte lokale Verbindungen (local interconnects), d.h. von Gräben mit geringer lateraler Reichweite von bspw. kleiner als 10 Mikrometer, durch bekannte Abfolgen von Belackung, lithographische Belichtung und Erzeugung von Lackmasken, plasmaunterstützte Ätzschritte und Lackstripp-Verfahren mittels bekannter Techniken der Halbleiterherstellung erzeugt. In einem anschließenden Reinigungsschritt werden bspw. physikalisch oder nasschemisch mittels bekannter Techniken der Halbleiterherstellung die so geschaffenen Kontaktlöcher bzw. Gräben gesäubert.

Danach wird der das Dielektrikum 80 tragende Wafer bspw. in eine Multikammeranlage zur Abscheidung von metallischen Schichten mit Grundvakuum von besser als 1 Torr bzw. 133 Pa eingebracht. Es folgt ein optionaler Degas-Schritt, z.B. durch Argon-Plasma-Sputtern.
Der Wafer wird in eine ALD-Kammer transportiert, wo bspw. 1 nm ALD RuO₂ einer Haftschicht 82 und bspw. 3 nm einer ersten Leitschicht 84 aus ALD Ru abgeschieden. Es werden die gleichen Prozessbedingungen wie beim Erzeugen der Haftschicht 50 bzw. der ersten Leitschicht 52 verwendet. Danach wird der Wafer in eine weitere ALD-Kammer transportiert, wo 2 nm ALD TaN einer Zwischenschicht 86 auf der ersten Leitschicht 84 abgeschieden werden, bspw. unter den gleichen Prozessbedingungen wie beim Erzeugen der Zwischenschicht 54.
Nach dem Transfer des Wafers in eine ALD-CVD-Kammer erfolgt die Abscheidung von 115 nm Wolfram zur Kontaktauffüllung durch bspw.:
- Spülen mit 20 sccm (Standard Kubikzentimeter) Silan SiH₄ Fluss bei 370 °C für 15 Sekunden bei p = 10 Torr bzw. 1333 Pa,
- Abscheiden einer zweiten Leitschicht 88 aus bspw. 5 nm ALD W mit Hilfe von alternierenden Wolframhexafluorid WF₆- und Silan SiH₄-Pulsen sowie zwischengelagerten N₂-Purge-Pulsen, von bspw. fünf Sekunden bei bspw. 370 °C,
- Abscheiden einer Hilfsschicht 90 aus bspw. 10 nm W-CVD mit Hilfe von Silan SiH₄ (wobei der Silangasfluss bspw. 10 sccm beträgt), Argon Ar (bspw. 130 sccm), molekularem Wasserstoff H₂ (bspw. 120 sccm) und Wolframhexafluorid WF₆ (bspw. 30 sccm) bei bspw. 370 °C für bspw. 8 Sekunden bei einem Druck von bspw. p = 10 Torr bzw. 1333 Pa,
- Abscheiden der Kontakthauptfüllung 92 aus bspw. 100 nm W-CVD unter Verwendung von Argon Ar (bspw. 350 sccm), molekularem Wasserstoff H₂ (bspw. 1700 sccm) und Wolframhexafluorid WF₆ (bspw. 330 sccm) bei bspw. 370 °C für bspw. 30 Sekunden bei einem Druck von bspw. p = 80 Torr bzw. 10664 Pa.

Danach werden die Wolfram-Durchkontaktierungen durch Entfernen von Teilen des Wolframs W, der Mehrschichtbarriere und des Dielektrikums 80 in mindestens einem CMP-Schritt mit nachfolgender Reinigung erzeugt. Es folgt die weitere Bearbeitung wie in den obigen Beispielen beschrieben oder gemäß dem Stand der Technik.

Erläutert wurde unter anderem eine integrierte Schaltungsanordnung 10, die eine elektrisch leitfähige Leitstruktur 16, 22 aus Kupfer oder einer Kupferlegierung enthält. An einer Seitenwand der Leitstruktur 16, 22 befindet sich ein Schichtstapel 32, der mindestens drei Schichten enthält. Trotz sehr dünner Schichten in dem Schichtstapel 32 lässt sich eine hohe Barrierewirkung gegen Kupferdiffusion verbunden mit einer hohen elektrischen Leitfähigkeit erreichen, wie sie für eine elektrolytische Kupferabscheidung mit Außenstrom benötigt wird.

Bei den erläuterten Ausführungsbeispielen sind weitere Schichten zwischen den erläuterten Schichten nicht vorhanden, abgesehen von sich ggf. bildenden binären Grenzschichten zwischen benachbarten Schichten. Jedoch werden bei anderen Ausführungsbeispielen weitere Schichten zwischen den erläuterten Schichten angeordnet, insbesondere Schichten mit Schichtdicken kleiner als 6 nm.

## Patentansprüche

1. Verfahren zum elektrolytischen Abscheiden einer Kupfer-Leitstruktur (68) in einer integrierten Schaltungsanordnung (10), mit den Schritten:
Erzeugen eines Schichtstapels (26b),
Verwenden der zuletzt erzeugten Leitschicht (58) des Schichtstapels (26b) für eine elektrolytische Abscheidung der Leitstruktur (68), wobei die Leitstruktur (68) aus Kupfer besteht,
wobei der Schichtstapel (26b) zwischen der Leitstruktur (68) und einem Dielektrikum (19b) an einer Seitenwand der Leitstruktur (68) angeordnet ist und in der folgenden Reihenfolge mit zunehmendem Abstand vom Dielektrikum (19b) enthält:
eine elektrisch leitfähige erste Leitschicht (62) mit einer Schichtdicke im Bereich von 5 Angström bis 60 Angström,
wobei die erste Leitschicht (62) aus einem ersten Material besteht und an das Dielektrikum (19b) angrenzt oder an eine zwischen der ersten Leitschicht (62) und dem Dielektrikum (19b) angeordnete elektrisch leitfähige Oxidschicht (60),
angrenzend an die erste Leitschicht (62) eine elektrisch leitfähige erste Zwischenschicht (64) mit einer Schichtdicke im Bereich von 2 Angström bis 30 Angström,
wobei die erste Zwischenschicht (64) aus einem anderen Material als die erste Leitschicht (62) besteht,
und wobei die erste Zwischenschicht (64) einen größeren spezifischen elektrischen Widerstand als die erste Leitschicht (62) hat,
angrenzend an die erste Zwischenschicht (64) und an die Leitstruktur (68) eine elektrisch leitfähige zweite Leitschicht (66) mit einer Schichtdicke im Bereich von 5 Angström bis 60 Angström,
wobei die zweite Leitschicht (66) aus einem anderen Material als die erste Zwischenschicht (64) besteht,
und wobei die zweite Leitschicht (66) einen kleineren spezifischen elektrischen Widerstand als die erste Zwischenschicht (64) hat,
wobei die erste Leitschicht eines der folgenden Materialien enthält oder aus einem der folgenden Materialien besteht: Ruthenium, Wolfram, Rhodium, Rhenium, Molybdän,
wobei die erste Zwischenschicht (64) eines der folgenden Materialien enthält oder aus einem der folgenden Materialien besteht: Tantal, Tantalnitrid, Tantalkarbid, Tantalkarbonitrid, Tantalsilizonitrid, Titannitrid, Titankarbid, Titankarbonitrid, Titansilizonitrid, Wolframnitrid, Wolframkarbid, Wolframkarbonitrid, Wolframsilizonitrid, Aluminium, Chrom, Nickel, Kobalt, Kohlenstoff,
wobei die zweite Leitschicht (66) eines der folgenden Materialien enthält oder aus einem der folgenden Materialien besteht: Ruthenium, Wolfram, Rhodium, Rhenium, Molybdän, Kupfer, Silber, Gold, Palladium, Platin.

2. Verfahren nach Anspruch 1, **dadurch gekennzeichnet, dass** die Leitschichten (62, 66) jeweils eine Schichtdicke im Bereich von 10 Angström bis 60 Angström haben, und dass die erste Zwischenschicht (64) eine Schichtdicke im Bereich von 2,5 Angström bis 30 Angström hat.

3. Verfahren zum elektrolytischen Abscheiden einer Kupfer-Leitstruktur (59) in einer integrierten Schaltungsanordnung (10), mit den Schritten:
Erzeugen eines Schichtstapels (26),
Verwenden der zuletzt erzeugten Leitschicht (58) des Schichtstapels (26) für eine elektrolytische Abscheidung der Leitstruktur (59), wobei die Leitstruktur (59, 68) aus Kupfer besteht,
und wobei der Schichtstapel (26b) zwischen der Leitstruktur (59) und einem Dielektrikum (19) an einer Seitenwand der Leitstruktur (59) angeordnet ist und in der folgenden Reihenfolge mit zunehmendem Abstand vom Dielektrikum (19) enthält:
eine elektrisch leitfähige erste Leitschicht (52) mit einer Schichtdicke im Bereich von 5 Angström bis 50 Angström,
wobei die erste Leitschicht (52) aus einem ersten Material besteht und an das Dielektrikum (19) angrenzt oder an eine zwischen der ersten Leitschicht (52) und dem Dielektrikum (19, 19b) angeordnete elektrisch leitfähige Oxidschicht (50), angrenzend an die erste Leitschicht (52) eine elektrisch leitfähige erste Zwischenschicht (54) mit einer Schichtdicke im Bereich von 2 Angström bis 25 Angström,
wobei die erste Zwischenschicht (54) aus einem anderen Material als die erste Leitschicht (52)besteht,
und wobei die erste Zwischenschicht (54) einen größeren spezifischen elektrischen Widerstand als die erste Leitschicht (52) hat,
angrenzend an die erste Zwischenschicht (54) eine elektrisch leitfähige zweite Leitschicht (56) mit einer Schichtdicke im Bereich von 5 Angström bis 50 Angström,
wobei die zweite Leitschicht (56) aus einem anderen Material als die erste Zwischenschicht (54) besteht,
und wobei die zweite Leitschicht (56) einen kleineren spezifischen elektrischen Widerstand als die erste Zwischenschicht, (54, 64, 86) hat,
eine zwischen der Leitstruktur (59) und der zweiten Leitschicht (56) angeordnete elektrisch leitfähige zweite Zwischenschicht (57) des Schichtstapels (26) mit einer Schichtdicke im Bereich von 2 Angström bis 25 Angström,
wobei die zweite Zwischenschicht (57) an die zweite Leitschicht (56) angrenzt,
wobei die zweite Zwischenschicht (57) aus einem anderen Material als die zweite Leitschicht (56) besteht,
und wobei die zweite Zwischenschicht (57) einen größeren spezifischen elektrischen Widerstand als die zweite Leitschicht (56) hat,
eine zwischen der zweiten Zwischenschicht (57) und der Leitstruktur (59) angeordnete elektrisch leitfähige dritte Leitschicht (58) des Schichtstapels (26) mit einer Schichtdicke im Bereich von 5 Angström bis 50 Angström,
wobei die dritte Leitschicht (58) an die zweite Zwischenschicht (57) und an die Leitstruktur angrenzt,
wobei die dritte Leitschicht (58) aus einem anderen Material als die zweite Zwischenschicht (57) besteht,
und wobei die dritte Leitschicht (58) einen kleineren spezifischen elektrischen Widerstand als die zweite Zwischenschicht (57) hat,
wobei die erste Leitschicht (52) eines der folgenden Materialien enthält oder aus einem der folgenden Materialien besteht: Ruthenium, Wolfram, Rhodium, Rhenium, Molybdän,
wobei die erste Zwischenschicht (54) eines der folgenden Materialien enthält oder aus einem der folgenden Materialien besteht: Tantal, Tantalnitrid, Tantalkarbid, Tantalkarbonitrid, Tantalsilizonitrid, Titannitrid, Titankarbid, Titankarbonitrid, Titansilizonitrid, Wolframnitrid, Wolframkarbid, Wolframkarbonitrid, Wolframsilizonitrid, Aluminium, Chrom, Nickel, Kobalt, Kohlenstoff,
wobei die zweite Leitschicht (56) eines der folgenden Materialien enthält oder aus einem der folgenden Materialien besteht: Ruthenium, Wolfram, Rhodium, Rhenium, Molybdän, Kupfer, Silber, Gold, Palladium, Platin,
wobei die zweite Zwischenschicht (57) eines der folgenden Materialien enthält oder aus einem der folgenden Materialien besteht: Tantal, Tantalnitrid, Tantalkarbid, Tantalkarbonitrid, Tantalsilizonitrid, Titannitrid, Titankarbid, Titankarbonitrid, Titansilizonitrid, Wolframnitrid, Wolframkarbid, Wolframkarbonitrid, Wolframsilizonitrid, Aluminium, Chrom, Nickel, Kobalt, Kohlenstoff,
wobei die dritte Leitschicht (58) eines der folgenden Materialien enthält oder aus einem der folgenden Materialien besteht: Ruthenium, Wolfram, Rhodium, Rhenium, Molybdän, Kupfer, Silber, Gold, Palladium, Platin.

4. Verfahren zum elektrolytischen Abscheiden einer KupferLeitstruktur (59) in einer integrierten Schaltungsanordnung (10), mit den Schritten:
Erzeugen des Schichtstapels (26),
Verwenden der zuletzt erzeugten Leitschicht des Schichtstapels (26) für eine elektrolytische Abscheidung der Leitstruktur (59), wobei die Leitstruktur (59) aus Kupfer besteht,
und wobei der Schichtstapel (26) zwischen der Leitstruktur (59) und einem Dielektrikum (19) an einer Seitenwand der Leitstruktur (59) angeordnet ist und in der folgenden Reihenfolge mit zunehmendem Abstand vom Dielektrikum (19) enthält:
eine elektrisch leitfähige erste Leitschicht (52) mit einer Schichtdicke im Bereich von 5 Angström bis 40 Angström,
wobei die erste Leitschicht (52) aus einem ersten Material besteht und an das Dielektrikum (19) angrenzt oder an eine zwischen der ersten Leitschicht (52) und dem Dielektrikum (19, 19b) angeordnete elektrisch leitfähige Oxidschicht (50), angrenzend an die erste Leitschicht (52) eine elektrisch leitfähige erste Zwischenschicht (54) mit einer Schichtdicke im Bereich von 2 Angström bis 25 Angström,
wobei die erste Zwischenschicht (54) aus einem anderen Material als die erste Leitschicht (52)besteht,
und wobei die erste Zwischenschicht (54) einen größeren spezifischen elektrischen Widerstand als die erste Leitschicht (52) hat,
angrenzend an die erste Zwischenschicht (54) eine elektrisch leitfähige zweite Leitschicht (56) mit einer Schichtdicke im Bereich von 5 Angström bis 40 Angström,
wobei die zweite Leitschicht (56) aus einem anderen Material als die erste Zwischenschicht (54) besteht,
und wobei die zweite Leitschicht (56) einen kleineren spezifischen elektrischen Widerstand als die erste Zwischenschicht (54, 64, 86) hat,
eine zwischen der Leitstruktur (59) und der zweiten Leitschicht (56) angeordnete elektrisch leitfähige zweite Zwischenschicht (57) des Schichtstapels (26) mit einer Schichtdicke im Bereich von 2 Angström bis 25 Angström,
wobei die zweite Zwischenschicht (57) an die zweite Leitschicht (56) angrenzt,
wobei die zweite Zwischenschicht (57) aus einem anderen Material als die zweite Leitschicht (56) besteht,
und wobei die zweite Zwischenschicht (57) einen größeren spezifischen elektrischen Widerstand als die zweite Leitschicht (56) hat,
eine zwischen der zweiten Zwischenschicht (57) und der Leitstruktur (59) angeordnete elektrisch leitfähige dritte Leitschicht (58) des Schichtstapels (26) mit einer Schichtdicke im Bereich von 5 Angström bis 40 Angström,
wobei die dritte Leitschicht (58) an die zweite Zwischenschicht (57) angrenzt,
wobei die dritte Leitschicht (58) aus einem anderen Material als die zweite Zwischenschicht (57) besteht,
und wobei die dritte Leitschicht (58) einen kleineren spezifischen elektrischen Widerstand als die zweite Zwischenschicht (57) hat,
eine zwischen der Leitstruktur (59) und der dritten Leitschicht (58) angeordnete elektrisch leitfähige dritte Zwischenschicht des Schichtstapels (26) mit einer Schichtdicke im Bereich von 2 Angström bis 25 Angström,
wobei die dritte Zwischenschicht an die dritte Leitschicht (58) angrenzt,
wobei die dritte Zwischenschicht aus einem anderen Material als die dritte Leitschicht (58) besteht,
und wobei die dritte Zwischenschicht, einen größeren spezifischen elektrischen Widerstand als die dritte Leitschicht (58) hat,
und eine zwischen der dritten Zwischenschicht und der Leitstruktur (59) angeordnete elektrisch leitfähige vierte Leitschicht des Schichtstapels (26) mit einer Schichtdicke im Bereich von 5 Angström bis 40 Angström,
wobei die vierte Leitschicht an die dritte Zwischenschicht und an die Leitstruktur angrenzt,
wobei die vierte Leitschicht aus einem anderen Material als die dritte Zwischenschicht besteht,
und wobei die vierte Leitschicht einen kleineren spezifischen elektrischen Widerstand als die dritte Zwischenschicht hat,
wobei die erste Leitschicht (52) eines der folgenden Materialien enthält oder aus einem der folgenden Materialien besteht: Ruthenium, Wolfram, Rhodium, Rhenium, Molybdän,
wobei die erste Zwischenschicht (54) eines der folgenden Materialien enthält oder aus einem der folgenden Materialien besteht: Tantal, Tantalnitrid, Tantalkarbid, Tantalkarbonitrid, Tantalsilizonitrid, Titannitrid, Titankarbid, Titankarbonitrid, Titansilizonitrid, Wolframnitrid, Wolframkarbid, Wolframkarbonitrid, Wolframsilizonitrid, Aluminium, Chrom, Nickel, Kobalt, Kohlenstoff,
wobei die zweite Leitschicht (56) eines der folgenden Materialien enthält oder aus einem der folgenden Materialien besteht: Ruthenium, Wolfram, Rhodium, Rhenium, Molybdän, Kupfer, Silber, Gold, Palladium, Platin,
wobei die zweite Zwischenschicht (57) eines der folgenden Materialien enthält oder aus einem der folgenden Materialien besteht: Tantal, Tantalnitrid, Tantalkarbid, Tantalkarbonitrid, Tantalsilizonitrid, Titannitrid, Titankarbid, Titankarbonitrid, Titansilizonitrid, Wolframnitrid, Wolframkarbid, Wolframkarbonitrid, Wolframsilizonitrid, Aluminium, Chrom, Nickel, Kobalt, Kohlenstoff,
wobei die dritte Leitschicht (58) eines der folgenden Materialien enthält oder aus einem der folgenden Materialien besteht: Ruthenium, Wolfram, Rhodium, Rhenium, Molybdän, Kupfer, Silber, Gold, Palladium, Platin,
wobei die dritte Zwischenschicht eines der folgenden Materialien enthält oder aus einem der folgenden Materialien besteht: Tantal, Tantalnitrid, Tantalkarbid, Tantalkarbonitrid, Tantalsilizonitrid, Titannitrid, Titankarbid, Titankarbonitrid, Titansilizonitrid, Wolframnitrid, Wolframkarbid, Wolframkarbonitrid, Wolframsilizonitrid, Aluminium, Chrom, Nickel, Kobalt, Kohlenstoff,
wobei die vierte Leitschicht eines der folgenden Materialien enthält oder aus einem der folgenden Materialien besteht: Ruthenium, Wolfram, Rhodium, Rhenium, Molybdän,
Kupfer, Silber, Gold, Palladium, Platin.

5. Verfahren nach einem der vorhergehenden Ansprüche, **dadurch gekennzeichnet, dass** das Material mindestens einer Zwischenschicht (54, 57) oder aller Zwischenschichten eine Kupferdiffusionsbarriere ist.

6. Verfahren nach einem der vorhergehenden Ansprüche, **dadurch gekennzeichnet, dass** der spezifische elektrische Widerstand des Materials mindestens einer Leitschicht (52, 56, 58) kleiner als 50 μΩcm ist.

7. Verfahren nach einem der vorhergehenden Ansprüche, **dadurch gekennzeichnet, dass** die erste Leitschicht (52, 62, 84) aus Ruthenium besteht oder Ruthenium enthält.

8. Verfahren nach Anspruch 7, **dadurch gekennzeichnet, dass** zwischen der ersten Leitschicht (52, 62, 84) und dem Dielektrikum (19, 19b) eine elektrisch leitfähige Rutheniumoxidschicht angeordnet ist.

9. Verfahren nach Anspruch 8, **dadurch gekennzeichnet, dass** die Oxidschicht (50, 60, 82) eine Schichtdicke im Bereich von 5 Angström bis 20 Angström hat.

10. Verfahren nach einem der Ansprüche 1 bis 6, **dadurch gekennzeichnet, dass**
die erste Leitschicht (52) aus Ruthenium besteht,
die erste Zwischenschicht (54) aus Tantalnitrid besteht,
und dass die zweite Gleitschicht (56) aus Ruthenium besteht.

11. Verfahren nach Anspruch 10 soweit auf Anspruch 3 oder 4 rückbezogen, **dadurch gekennzeichnet, dass** die zweite Zwischenschicht (57) des Schichtstapels (26) aus Tantalnitrid besteht, und
dass die dritte Leitschicht (58) des Schichtstapels (26) aus Ruthenium besteht.

12. Verfahren nach einem der Ansprüche 1 bis 6, **dadurch gekennzeichnet, dass**
die erste Leitschicht (62) aus Ruthenium besteht,
die erste Zwischenschicht (64) aus Titannitrid besteht,
und dass die zweite Leitschicht (66) aus Ruthenium besteht.

13. Verfahren nach einem der vorhergehenden Ansprüche, **dadurch gekennzeichnet, dass** die der Leitstruktur nächste Leitschicht des Schichtstapels aus einem anderen Material als die Leitstruktur besteht.

14. Integrierte Schaltungsanordnung,
mit einer elektrisch leitfähigen Leitstruktur (92),
mit einem zwischen der Leitstruktur (92) und einem Dielektrikum (80) an einer Seitenwand der Leitstruktur (92) angeordneten Schichtstapel (78), der in der folgenden Reihenfolge mit zunehmendem Abstand vom Dielektrikum (80) enthält:
eine elektrisch leitfähige erste Leitschicht (84) mit einer Schichtdicke im Bereich von 5 Angström bis 60 Angström,
wobei die erste Leitschicht (84) aus einem ersten Material besteht,
eine elektrisch leitfähige erste Zwischenschicht (86) mit einer Schichtdicke im Bereich von 2 Angström bis 30 Angström,
wobei die erste Zwischenschicht (86) aus einem anderen Material als die erste Leitschicht (84) besteht,
und wobei die erste Zwischenschicht (86) einen größeren spezifischen elektrischen Widerstand als die erste Leitschicht (84) hat,
eine elektrisch leitfähige zweite Leitschicht (88) mit einer Schichtdicke im Bereich von 5 Angström bis 60 Angström,
wobei die zweite Leitschicht (88) aus einem anderen Material als die erste Zwischenschicht (86) besteht,
und wobei die zweite Leitschicht (88) einen kleineren spezifischen elektrischen Widerstand als die erste Zwischenschicht (86) hat,
**dadurch gekennzeichnet, dass**
die erste Leitschicht (84) aus Ruthenium besteht,
die erste Zwischenschicht (86) aus Tantalnitrid oder Titannitrid besteht,
und dass die zweite Leitschicht (88) aus Wolfram besteht.

15. Schaltungsanordnung (10) nach Anspruch 14, **dadurch gekennzeichnet, dass** die Leitstruktur (92) aus Wolfram besteht oder Wolfram enthält.

## Claims

1. Process for the electrolytic deposition of a copper conduction structure (68) in an integrated circuit arrangement (10), comprising the steps of:
producing a layer stack (26b),
using the conduction layer (58) produced last in the layer stack (26b) for an electrolytic deposition of the conduction structure (68),
wherein the conduction structure (68) consists of copper,
wherein the layer stack (26b) is arranged between the conduction structure (68) and a dielectric (19b) at a side wall of the conduction structure (68) and includes, in the following order at increasing distance from the dielectric (19b):
an electrically conductive first conduction layer (62) with a layer thickness in the range from 5 Angström to 60 Angström,
wherein the first conduction layer (62) consists of a first material and adjoins the dielectric (19b) or an electrically conductive oxide layer (60) arranged between the first conduction layer (62) and the dielectric (19b),
adjoining the first conduction layer (62), an electrically conductive first interlayer (64) with a layer thickness in the range from 2 Angström to 30 Angström,
wherein the first interlayer (64) consists of a different material than the first conduction layer (62),
and wherein the first interlayer (64) has a higher electrical resistivity than the first conduction layer (62),
adjoining the first interlayer (64) and the conduction structure (68), an electrically conductive second conduction layer (66) with a layer thickness in the range from 5 Angström to 60 Angström,
wherein the second conduction layer (66) consists of a different material than the first interlayer (64),
and wherein the second conduction layer (66) has a lower electrical resistivity than the first interlayer (64),
wherein the first conduction layer contains one of the following materials or consists of one of the following materials: ruthenium, tungsten, rhodium, rhenium, molybdenum,
wherein the first interlayer (64) contains one of the following materials or consists of one of the following materials: tantalum, tantalum nitride, tantalum carbide, tantalum carbonitride, tantalum siliconitride, titanium nitride, titanium carbide, titanium carbonitride, titanium siliconitride, tungsten nitride, tungsten carbide, tungsten carbonitride, tungsten siliconitride, aluminium, chromium, nickel, cobalt, carbon,
wherein the second conduction layer (66) contains one of the following materials or consists of one of the following materials: ruthenium, tungsten, rhodium, rhenium, molybdenum, copper, silver, gold, palladium, platinum.

2. Process according to Claim 1, **characterized in that** the conduction layers (62, 66) each have a layer thickness in the range from 10 Angström to 60 Angström, and **in that** the first interlayer (64) has a layer thickness in the range from 2.5 Angström to 30 Angström.

3. Process for the electrolytic deposition of a copper conduction structure (59) in an integrated circuit arrangement (10), comprising the steps of:
producing a layer stack (26),
using the conduction layer (58) produced last in the layer stack (26) for an electrolytic deposition of the conduction structure (59),
wherein the conduction structure (59, 68) consists of copper,
and wherein the layer stack (26b) is arranged between the conduction structure (59) and a dielectric (19) at a side wall of the conduction structure (59) and includes, in the following order at increasing distance from the dielectric (19) :
an electrically conductive first conduction layer (52) with a layer thickness in the range from 5 Angström to 50 Angström,
wherein the first conduction layer (52) consists of a first material and adjoins the dielectric (19) or an electrically conductive oxide layer (50) arranged between the first conduction layer (52) and the dielectric (19, 19b),
adjoining the first conduction layer (52), an electrically conductive first interlayer (54) with a layer thickness in the range from 2 Angström to 25 Angström,
wherein the first interlayer (54) consists of a different material than the first conduction layer (52),
and wherein the first interlayer (54) has a higher electrical resistivity than the first conduction layer (52),
adjoining the first interlayer (54), an electrically conductive second conduction layer (56) with a layer thickness in the range from 5 Angström to 50 Angström,
wherein the second conduction layer (56) consists of a different material than the first interlayer (54),
and wherein the second conduction layer (56) has a lower electrical resistivity than the first interlayer (54, 64, 86),
an electrically conductive second interlayer (57) of the layer stack (26) which is arranged between the conduction structure (59) and the second conduction layer (56) and has a layer thickness in the range from 2 Angström to 25 Angström,
wherein the second interlayer (57) adjoins the second conduction layer (56),
wherein the second interlayer (57) consists of a different material than the second conduction layer (56),
and wherein the second interlayer (57) has a higher electrical resistivity than the second conduction layer (56),
an electrically conductive third conduction layer (58) of the layer stack (26) which is arranged between the second interlayer (57) and the conduction structure (59) and has a layer thickness in the range from 5 Angström to 50 Angström,
wherein the third conduction layer (58) adjoins the second interlayer (57) and the conduction structure,
wherein the third conduction layer (58) consists of a different material than the second interlayer (57),
and wherein the third conduction layer (58) has a lower electrical resistivity than the second interlayer (57),
wherein the first conduction layer (52) contains one of the following materials or consists of one of the following materials: ruthenium, tungsten, rhodium, rhenium, molybdenum,
wherein the first interlayer (54) contains one of the following materials or consists of one of the following materials: tantalum, tantalum nitride,
tantalum carbide, tantalum carbonitride, tantalum siliconitride, titanium nitride, titanium carbide,
titanium carbonitride, titanium siliconitride,
tungsten nitride, tungsten carbide, tungsten carbonitride, tungsten siliconitride, aluminium, chromium, nickel, cobalt, carbon,
wherein the second conduction layer (56) contains one of the following materials or consists of one of the following materials: ruthenium, tungsten, rhodium, rhenium, molybdenum, copper, silver, gold, palladium, platinum,
wherein the second interlayer (57) contains one of the following materials or consists of one of the following materials: tantalum, tantalum nitride, tantalum carbide, tantalum carbonitride, tantalum siliconitride, titanium nitride, titanium carbide, titanium carbonitride, titanium siliconitride, tungsten nitride, tungsten carbide, tungsten carbonitride, tungsten siliconitride, aluminium, chromium, nickel, cobalt, carbon,
wherein the third conduction layer (58) contains one of the following materials or consists of one of the following materials: ruthenium, tungsten, rhodium, rhenium, molybdenum, copper, silver, gold, palladium, platinum.

4. Process for the electrolytic deposition of a copper conduction structure (59) in an integrated circuit arrangement (10), comprising the steps of:
producing the layer stack (26),
using the conduction layer produced last in the layer stack (26) for an electrolytic deposition of the conduction structure (59), wherein the conduction structure (59) consists of copper,
and wherein the layer stack (26) is arranged between the conduction structure (59) and a dielectric (19) at a side wall of the conduction structure (59) and includes, in the following order at increasing distance from the dielectric (19) :
an electrically conductive first conduction layer (52) with a layer thickness in the range from 5 Angström to 40 Angström,
wherein the first conduction layer (52) consists of a first material and adjoins the dielectric (19) or an electrically conductive oxide layer (50) arranged between the first conduction layer (52) and the dielectric (19, 19b),
adjoining the first conduction layer (52), an electrically conductive first interlayer (54) with a layer thickness in the range from 2 Angström to 25 Angström,
wherein the first interlayer (54) consists of a different material than the first conduction layer (52),
and wherein the first interlayer (54) has a higher electrical resistivity than the first conduction layer (52),
adjoining the first interlayer (54), an electrically conductive second conduction layer (56) with a layer thickness in the range from 5 Angström to 40 Angström,
wherein the second conduction layer (56) consists of a different material than the first interlayer (54),
and wherein the second conduction layer (56) has a lower electrical resistivity than the first interlayer (54, 64, 86),
an electrically conductive second interlayer (57) of the layer stack (26) which is arranged between the conduction structure (59) and the second conduction layer (56) and has a layer thickness in the range from 2 Angström to 25 Angström,
wherein the second interlayer (57) adjoins the second conduction layer (56),
wherein the second interlayer (57) consists of a different material than the second conduction layer (56),
and wherein the second interlayer (57) has a higher electrical resistivity than the second conduction layer (56),
an electrically conductive third conduction layer (58) of the layer stack (26) which is arranged between the second interlayer (57) and the conduction structure (59) and has a layer thickness in the range from 5 Angström to 40 Angström,
wherein the third conduction layer (58) adjoins the second interlayer (57),
wherein the third conduction layer (58) consists of a different material than the second interlayer (57),
and wherein the third conduction layer (58) has a lower electrical resistivity than the second interlayer (57),
an electrically conductive third interlayer of the layer stack (26) which is arranged between the conduction structure (59) and the third conduction layer (58) and has a layer thickness in the range from 2 Angström to 25 Angström,
wherein the third interlayer adjoins the third conduction layer (58),
wherein the third interlayer consists of a different material than the third conduction layer (58),
and wherein the third interlayer has a higher electrical resistivity than the third conduction layer (58),
and an electrically conductive fourth conduction layer of the layer stack (26) which is arranged between the third interlayer and the conduction structure (59) and has a layer thickness in the range from 5 Angström to 40 Angström,
wherein the fourth conduction layer adjoins the third interlayer and the conduction structure,
wherein the fourth conduction layer consists of a different material than the third interlayer,
and wherein the fourth conduction layer has a lower electrical resistivity than the third interlayer,
wherein the first conduction layer (52) contains one of the following materials or consists of one of the following materials: ruthenium, tungsten, rhodium, rhenium, molybdenum,
wherein the first interlayer (54) contains one of the following materials or consists of one of the following materials: tantalum, tantalum nitride, tantalum carbide, tantalum carbonitride, tantalum siliconitride, titanium nitride, titanium carbide, titanium carbonitride, titanium siliconitride, tungsten nitride, tungsten carbide, tungsten carbonitride, tungsten siliconitride, aluminium, chromium, nickel, cobalt, carbon,
wherein the second conduction layer (56) contains one of the following materials or consists of one of the following materials: ruthenium, tungsten, rhodium, rhenium, molybdenum, copper, silver, gold, palladium, platinum,
wherein the second interlayer (57) contains one of the following materials or consists of one of the following materials: tantalum, tantalum nitride, tantalum carbide, tantalum carbonitride, tantalum siliconitride, titanium nitride, titanium carbide, titanium carbonitride, titanium siliconitride, tungsten nitride, tungsten carbide, tungsten carbonitride, tungsten siliconitride, aluminium, chromium, nickel, cobalt, carbon,
wherein the third conduction layer (58) contains one of the following materials or consists of one of the following materials: ruthenium, tungsten, rhodium, rhenium, molybdenum, copper, silver, gold, palladium, platinum,
wherein the third interlayer contains one of the following materials or consists of one of the following materials: tantalum, tantalum nitride, tantalum carbide, tantalum carbonitride, tantalum siliconitride, titanium nitride, titanium carbide, titanium carbonitride, titanium siliconitride, tungsten nitride, tungsten carbide, tungsten carbonitride, tungsten siliconitride, aluminium, chromium, nickel, cobalt, carbon,
wherein the fourth conduction layer contains one of the following materials or consists of one of the following materials: ruthenium, tungsten, rhodium, rhenium, molybdenum, copper, silver, gold, palladium, platinum.

5. Process according to one of the preceding claims, **characterized in that** the material of at least one interlayer (54, 57) or of all the interlayers is a copper diffusion barrier.

6. Process according to one of the preceding claims, **characterized in that** the electrical resistivity of the material of at least one conduction layer (52, 56, 58) is less than 50 μΩ cm.

7. Process according to one of the preceding claims, **characterized in that** the first conduction layer (52, 62, 84) consists of ruthenium or contains ruthenium.

8. Process according to Claim 7, **characterized in that** an electrically conductive ruthenium oxide layer is arranged between the first conduction layer (52, 62, 84) and the dielectric (19, 19b).

9. Process according to Claim 8, **characterized in that** the oxide layer (50, 60, 82) has a layer thickness in the range from 5 Angström to 20 Angström.

10. Process according to one of Claims 1 to 6, **characterized in that**
the first conduction layer (52) consists of ruthenium,
the first interlayer (54) consists of tantalum nitride,
and **in that** the second conduction layer (56) consists of ruthenium.

11. Process according to Claim 10, in so far as it refers back to Claim 3 or 4, **characterized in that** the second interlayer (57) of the layer stack (26) consists of tantalum nitride, and
**in that** the third conduction layer (58) of the layer stack (26) consists of ruthenium.

12. Process according to one of Claims 1 to 6, **characterized in that**
the first conduction layer (62) consists of ruthenium,
the first interlayer (64) consists of titanium nitride,
and **in that** the second conduction layer (66) consists of ruthenium.

13. Process according to one of the preceding claims, **characterized in that** the conduction layer of the layer stack next to the conduction structure consists of a different material than the conduction structure.

14. Integrated circuit arrangement,
having an electrically conductive conduction structure (92),
having a layer stack (78) arranged between the conduction structure (92) and a dielectric (80) at a side wall of the conduction structure (92), which layer stack includes, in the following order at increasing distance from the dielectric (80):
an electrically conductive first conduction layer (84) with a layer thickness in the range from 5 Angström to 60 Angström,
wherein the first conduction layer (84) consists of a first material,
an electrically conductive first interlayer (86) with a layer thickness in the range from 2 Angström to 30 Angström,
wherein the first interlayer (86) consists of a different material than the first conduction layer (84),
and wherein the first interlayer (86) has a higher electrical resistivity than the first conduction layer (84),
an electrically conductive second conduction layer (88) with a layer thickness in the range from 5 Angström to 60 Angström,
wherein the second conduction layer (88) consists of a different material than the first interlayer (86),
and wherein the second conduction layer (88) has a lower electrical resistivity than the first interlayer (86),
**characterized in that**
the first conduction layer (84) consists of ruthenium,
the first interlayer (86) consists of tantalum nitride or titanium nitride,
and **in that** the second conduction layer (88) consists of tungsten.

15. Circuit arrangement (10) according to Claim 14, **characterized in that** the conduction structure (92) consists of tungsten or contains tungsten.

## Revendications

1. Procédé de dépôt électrolytique d'une structure (68) conductrice en cuivre dans un circuit (10) intégré, comprenant les stades :
production d'un empilement (26b) de couches,
utilisation de la couche (58) conductrice produite en dernier de l'empilement (26b) de couches pour un dépôt électrolytique de la structure (68) conductrice, la structure (68) conductrice étant en cuivre,
dans lequel l'empilement (26b) de couches est disposé entre la structure (68) conductrice et un diélectrique (19b) sur une paroi latérale de la structure (68) conductrice et contient dans la succession suivante au fur et à mesure qu'augmente la distance au diélectrique (19b) :
une première couche (62) conductrice de l'électricité ayant une épaisseur dans la plage de 5 angstrôm à 60 angstrôm,
la première couche (62) conductrice étant en un premier matériau et étant voisine du diélectrique (19b) ou voisine d'une couche (60) d'oxyde conductrice de l'électricité disposée entre la première couche (62) conductrice et le diélectrique (19b), étant voisine de la première couche (62) conductrice une première couche (64) intermédiaire conductrice de l'électricité ayant une épaisseur dans la plage de 2 angstrôm à 30 angstrôm,
la première couche (64) intermédiaire étant en un matériau autre que la première couche (62) conductrice,
et la première couche (64) intermédiaire ayant une résistivité électrique plus grande que la première couche (62) conductrice,
étant voisine de la première couche (64) intermédiaire et de la structure (68) conductrice une deuxième couche (66) conductrice de l'électricité ayant une épaisseur dans la plage de 5 angström à 60 angström,
la deuxième couche (66) conductrice étant en un matériau autre que la première couche (64) intermédiaire,
et la deuxième couche (66) conductrice ayant une résistivité électrique plus petite que la première couche (64) intermédiaire,
la première couche conductrice contenant l'un des matériaux suivants ou en étant constituée : ruthénium, tungstène, rhodium, molybdène,
la première couche (64) intermédiaire contenant l'un des matériaux suivants ou en étant constituée : tantale, nitrure de tantale, carbure de tantale, carbonitrure de tantale, siliconitrure de tantale, nitrure de titane, carbure de titane, carbonitrure de titane, siliconitrure de titane, nitrure de tungstène, carbure de tungstène, carbonitrure de tungstène, siliconitrure de tungstène, aluminium, chrome, nickel, cobalt, carbone,
la deuxième couche (66) conductrice contenant l'un des matériaux suivants ou en étant constituée : ruthénium, tungstène, rhodium, rhénium, molybdène, cuivre, argent, or, palladium, platine.

2. Procédé suivant la revendication 1,
**caractérisé en ce que** les couches (62, 66) conductrices ont chacune une épaisseur dans la plage de 10 angström à 60 angström et **en ce que** la première couche (64) intermédiaire a une épaisseur dans la plage de 2,5 angström à 30 angström.

3. Procédé de dépôt électrolytique d'une structure (59) conductrice de cuivre dans un circuit (10) intégré, comprenant les stades :
production d'un empilement (26) de couches,
utilisation de la couche (58) conductrice produite en dernier de l'empilement (26) de couches pour un dépôt électrolytique de la structure (59) conductrice, la structure (59, 68) conductrice étant en cuivre,
et dans lequel l'empilement (26b) de couches est disposé entre la structure (59) conductrice et un diélectrique (19) sur une paroi latérale de la structure (59) conductrice et contient dans la succession suivante au fur et à mesure qu'augmente la distance au diélectrique (19) :
une première couche (52) conductrice de l'électricité ayant une épaisseur dans la plage de 5 angström à 50 angström,
la première couche (52) conductrice étant en un premier matériau et étant voisine du diélectrique (19), ou étant voisine d'une couche (50) d'oxyde conductrice de l'électricité disposée entre la première couche (52) conductrice et le diélectrique (19, 19b),
étant voisine de la première couche (52) conductrice une première couche (54) intermédiaire conductrice de l'électricité ayant une épaisseur dans la plage de 2 Angström à 25 Angström,
la première couche (54) intermédiaire étant en un matériau autre que la première couche (52) conductrice,
et la première couche (54) intermédiaire ayant une résistibilité électrique plus grande que la première couche (52) conductrice,
étant voisine de la première couche (54) intermédiaire une deuxième couche (56) conductrice de l'électricité ayant une épaisseur dans la plage de 5 angström à 50 angström,
la deuxième couche (56) conductrice étant en un matériau autre que la première couche (54) intermédiaire,
et la deuxième couche (56) conductrice ayant une résistivité électrique plus petite que la première couche (54, 64, 86) intermédiaire,
une deuxième couche (57) intermédiaire conductrice de l'électricité disposée entre la structure (59) conductrice et
la deuxième couche (56) conductrice de l'empilement (26) de couches en ayant une épaisseur dans la plage de 2 angström à 25 angström,
la deuxième couche (57) intermédiaire étant voisine de la deuxième couche (56) conductrice,
la deuxième couche (57) intermédiaire étant en un matériau autre que la deuxième couche (56) conductrice,
et la deuxième couche (57) intermédiaire ayant une résistivité électrique plus grande que la deuxième couche (56) conductrice,
une troisième couche (58) conductrice de l'électricité disposée entre la deuxième couche (57) intermédiaire et la structure (59) conductrice de l'empilement (26) de couches ayant une épaisseur dans la plage de 5 angström à 50 angström,
la troisième couche (58) conductrice étant voisine de la deuxième couche (57) intermédiaire et de la structure conductrice,
la troisième couche (58) conductrice étant en un matériau autre que la deuxième couche (57) intermédiaire,
et la troisième couche (58) conductrice ayant une résistivité électrique plus petite que la deuxième couche (57) intermédiaire,
la première couche (52) conductrice contenant l'un des matériau suivant ou en étant constituée : ruthénium, tungstène, rhodium, rhénium, molybdène,
la première couche (54) intermédiaire contenant l'un des matériau suivant ou en étant constituée : tantale, nitrure de tantale, carbure de tantale, carbonitrure de tantale, siliconitrure de tantale, nitrure de titane, carbure de titane, carbonitrure de titane, siliconitrure de titane, nitrure de tungstène, carbure de tungstène, carbonitrure de tungstène, siliconitrure de tungstène, aluminium, chrome, nickel, cobalt, carbone,
la deuxième couche (56) conductrice contenant l'un des matériaux suivant ou en étant constituée : ruthénium, tungstène, rhodium, rhénium, molybdène, cuivre, argent, or, palladium, platine,
la deuxième couche (57) intermédiaire contenant l'un des matériaux suivants ou en étant constituée : tantale, nitrure de tantale, carbure de tantale, carbonitrure de tantale, siliconitrure de tantale, nitrure de titane, carbure de titane, carbonitrure de titane, siliconitrure de titane, nitrure de tungstène, carbure de tungstène, carbonitrure de tungstène, siliconitrure de tungstène, aluminium, chrome, nickel, cobalt, carbone,
la troisième couche (58) conductrice contenant l'un des matériaux suivants ou en étant constituée : ruthénium, tungstène, rhodium, rhénium, molybdène, cuivre, argent, or, palladium, platine.

4. Procédé de dépôt électrolytique d'une structure (59) conductrice de cuivre dans un circuit (10) intégré, comprenant les stades :
production d'un empilement (26) de couches,
utilisation de la couche (58) conductrice produite en dernier de l'empilement (26) de couches pour un dépôt électrolytique de la structure (59) conductrice, la structure (59) conductrice étant en cuivre,
et dans lequel l'empilement (26) de couches est disposé entre la structure (59) conductrice et un diélectrique (19) sur une paroi latérale de la structure (59) conductrice et contenant dans la succession suivante au fur et à mesure qu'augmente la distance au diélectrique (19) :
une première couche (52) conductrice de l'électricité ayant une épaisseur dans la plage de 5 angström à 40 angström,
la première couche (52) conductrice étant en un premier matériau et étant voisine du diélectrique (19) ou étant voisine d'une couche (50) d'oxyde conductrice de l'électricité disposée entre la première couche (52) conductrice et le diélectrique (19, 19b),
étant voisine de la première couche (52) conductrice de l'électricité une première couche (54) intermédiaire conductrice de l'électricité ayant une épaisseur dans la plage de 2 angström à 25 angström,
la première couche (54) intermédiaire étant en un matériau autre que la première couche (52) conductrice,
et la première couche (54) intermédiaire ayant une résistibilité électrique plus grande que la première couche (52) conductrice,
étant voisine de la première couche (54) intermédiaire une deuxième couche (56) conductrice de l'électricité ayant une épaisseur dans la plage de 5 angström à 40 angström,
la deuxième couche (56) conductrice étant en un matériau autre que la première couche (54) intermédiaire,
et la deuxième couche (56) conductrice ayant une résistivité électrique plus petite que la première couche (54, 64, 86) intermédiaire,
une deuxième couche (57) intermédiaire de l'empilement (26) de couches, conductrice de l'électricité, disposée entre la structure (59) conductrice et la deuxième couche (56) conductrice et ayant une épaisseur dans la plage de 2 angström à 25 angström,
la deuxième couche (57) intermédiaire étant voisine de la deuxième couche (56) conductrice,
la deuxième couche (57) intermédiaire étant en un matériau autre que la deuxième couche (56) conductrice,
et la deuxième couche (57) intermédiaire ayant une résistivité électrique plus grande que la deuxième couche (56) conductrice,
une troisième couche (58) de l'empilement (26) de couches,
conductrice de l'électricité, disposée entre la deuxième couche (57) intermédiaire et la structure (59) conductrice et
ayant une épaisseur dans la plage de 5 angström à 40 angström,
la troisième couche (58) conductrice étant voisine de la deuxième couche (57) intermédiaire,
la troisième couche (58) conductrice étant en un matériau autre que la deuxième couche (57) intermédiaire,
et la troisième couche (58) conductrice ayant une résistivité électrique plus petite que la deuxième couche (57) intermédiaire,
une troisième couche intermédiaire de l'empilement (26) de couches conductrice de l'électricité et disposée entre la structure (59) conductrice et la troisième couche (58) conductrice ayant une épaisseur dans la plage de 2 angström à 25 angström,
la troisième couche intermédiaire étant voisine de la troisième couche (58) conductrice,
la troisième couche intermédiaire étant en un matériau autre que la troisième couche (58) conductrice,
et la troisième couche intermédiaire ayant une résistivité électrique plus grande que la troisième couche (58) conductrice,
et une quatrième couche (26) conductrice de l'électricité,
disposée entre la troisième couche intermédiaire et la structure (59) conductrice, ayant une épaisseur dans la plage de 5 angström à 40 angström,
la quatrième couche conductrice étant voisine de la troisième couche intermédiaire et de la structure conductrice,
la quatrième couche conductrice étant en un matériau autre que la troisième couche intermédiaire,
et la quatrième couche conductrice ayant une résistivité électrique plus petite que la troisième couche intermédiaire,
la première couche (52) conductrice contenant l'un des matériaux suivants ou en étant constituée : ruthénium, tungstène, rhodium, rhénium, molybdène,
la première couche (54) intermédiaire contenant l'un des matériaux suivants ou en étant constituée : tantale, nitrure de tantale, carbure de tantale, carbonitrure de tantale,
siliconitrure de tantale, nitrure de titane, carbure de titane, carbonitrure de titane, siliconitrure de titane,
nitrure de tungstène, carbure de tungstène, carbonitrure de tungstène, siliconitrure de tungstène, aluminium, chrome, nickel, cobalt, carbone,
la deuxième couche (56) conductrice contenant l'un des matériaux suivants ou en étant constituée : ruthénium, tungstène, rhodium, rhénium, molybdène, cuivre, argent, or, palladium, platine,
la deuxième couche (57) intermédiaire contenant l'un des matériaux suivants ou en étant constituée : tantale, nitrure de tantale, carbure de tantale, carbonitrure de tantale,
siliconitrure de tantale, nitrure de titane, carbure de titane, carbonitrure de titane, siliconitrure de titane,
nitrure de tungstène, carbure de tungstène, carbonitrure de tungstène, siliconitrure de tungstène, aluminium, chrome, nickel, cobalt, carbone,
la troisième couche (58) conductrice contenant l'un des matériaux suivants ou en étant constituée : ruthénium, tungstène, rhodium, rhénium, molybdène, cuivre, argent, or, palladium, platine,
la troisième couche intermédiaire contenant l'un des matériaux suivants ou en étant constituée : tantale, nitrure de tantale,
carbure de tantale, carbonitrure de tantale, siliconitrure de tantale, nitrure de titane, carbure de titane, carbonitrure de titane, siliconitrure de titane, nitrure de tungstène, carbure de tungstène, carbonitrure de tungstène, siliconitrure de tungstène, aluminium, chrome, nickel, cobalt, carbone,
la quatrième couche conductrice contenant l'un des matériaux suivants ou en étant constituée : ruthénium, tungstène, rhodium, rhénium, molybdène, cuivre, argent, or, palladium, platine.

5. Procédé suivant l'une des revendications précédentes, **caractérisé en ce que** le matériau d'au moins l'une des couches (54, 57) intermédiaire, ou de toutes les couches intermédiaires, est une barrière de diffusion du cuivre.

6. Procédé suivant l'une des revendications précédentes, **caractérisé en ce que** la résistivité électrique du matériau d'au moins l'une des couches (52, 56, 58) conductrices est plus petite que 50 μΩcm.

7. Procédé suivant l'une des revendications précédentes, **caractérisé en ce que** la première couche (52, 62, 84) conductrice est en ruthénium ou en contient.

8. Procédé suivant la revendication 7, **caractérisé en ce qu'**une couche d'oxyde de ruthénium conductrice de l'électricité est disposée entre la première couche (52, 62, 84) conductrice et le diélectrique (19, 19b).

9. Procédé suivant la revendication 8, **caractérisé en ce que** la couche (50, 60, 82) d'oxyde a une épaisseur dans la plage de 5 angström à 20 angström.

10. Procédé suivant l'une des revendications 1 à 6, **caractérisé en ce que**
la première couche (52) conductrice est en ruthénium,
la première couche (54) intermédiaire est en nitrure de tantale,
et la deuxième couche (56) conductrice est en ruthénium.

11. Procédé suivant la revendication 10, dans la mesure où elle se rattache à la revendication 3 ou 4, **caractérisé en ce que** la deuxième couche (57) intermédiaire de l'empilement (26) de couches est en nitrure de tantale et
**en ce que** la troisième couche (58) conductrice de l'empilement (26) de couches est en ruthénium.

12. Procédé suivant l'une des revendications 1 à 6, **caractérisé en ce que**
la première couche (62) conductrice est en ruthénium,
la première couche (64) intermédiaire est en nitrure de titane,
et la deuxième couche (66) conductrice est en ruthénium.

13. Procédé suivant l'une des revendications précédentes, **caractérisé en ce que** la couche conductrice du début suivant immédiatement la structure conductrice, de l'empilement de couches, est en un matériau autre que la structure conductrice.

14. Circuit intégré,
comprenant une structure (92) conductrice de l'électricité, comprenant un empilement (78) de couches qui est disposé entre la structure (92) conductrice et un diélectrique sur une paroi latérale de la structure (92) conductrice et qui contient dans la succession suivante, au fur et à mesure qu'augmente la distance au diélectrique (80) :
une première couche (84) conductrice de l'électricité ayant une épaisseur dans la plage de 5 angström à 60 angström,
la première couche (84) conductrice étant en un premier matériau,
une première couche (86) intermédiaire conductrice de l'électricité ayant une épaisseur dans la plage de 2 angström à 30 angström,
la première couche (86) intermédiaire étant en un matériau autre que la première couche (84) conductrice,
et la première couche (86) intermédiaire ayant une résistivité électrique plus grande que la première couche (84) conductrice,
une deuxième couche (88) conductrice de l'électricité ayant une épaisseur dans la plage de 5 angström à 60 angström,
la deuxième couche (88) conductrice étant en un matériau autre que la première couche (86) intermédiaire,
et la deuxième couche (88) conductrice ayant une résistivité électrique plus petite que la première couche (86) intermédiaire,
**caractérisé en ce que**
la première couche (84) conductrice est en ruthénium,
la première couche (86) intermédiaire est en nitrure de tantale ou en nitrure de titane
et la deuxième couche (88) conductrice est en tungstène.

15. Circuit (10) suivant la revendication 14, **caractérisé en ce que** la structure (92) conductrice est en tungstène ou en contient.
